(19) Europäisches Patentamt
European Patent Office
Office européen des brevets

(11) Publication number: **0 287 020**
**A2**

# (12) EUROPEAN PATENT APPLICATION

(21) Application number: 88105755.8

(22) Date of filing: 12.04.88

(51) Int. Cl.[4] **C08F 299/00 , C08F 267/06 , C08F 8/14 , C09D 3/00**

(30) Priority: 16.04.87 US 39184

(43) Date of publication of application: 19.10.88 Bulletin 88/42

(84) Designated Contracting States: AT BE CH DE ES FR GB GR IT LI LU NL SE

(71) Applicant: **W.R. GRACE & CO.**
**Grace Plaza 1114 Avenue of the Americas**
**New York New York 10036(US)**

(72) Inventor: **Kyle, David Ray**
**9421 Grait Hill Road**
**Columbia, MD 21046(US)**

(74) Representative: **UEXKÜLL & STOLBERG**
**Patentanwälte**
**Beselerstrasse 4**
**D-2000 Hamburg 52(DE)**

## (54) Aqueous developable, curable composition of matter.

(57) This invention relates to a novel, curable, aqueous developable composition comprising the reaction product of a mono(meth)acrylate derivative of a caprolactone diol and a styrene-maleic anhydride copolymer.

The exposure of the composition optionally also with a reactive diluent and a photo-or thermal initiator to heat, UV or high energy ionizing radiation results in solid cured products which are useful for making coatings, printing plates and photoresists.

EP 0 287 020 A2

# AQUEOUS DEVELOPABLE, CURABLE COMPOSITION OF MATTER

## BACKGROUND OF THE INVENTION

### 1. Field of the Invention

This invention relates to a novel composition of matter curable by a free radical mechanism comprising the reaction product of a mono(meth)acrylate derivative of a caprolactone diol and a styrene-maleic anhydride copolymer. The reaction product either alone or in conjunction with other materials may be used as a coating or a photoresist in making printed circuit boards by etching or plating processes. For brevity hereinafter the novel composition will in the main be referred to as "the reaction product" or "the reaction product composition".

The curable reaction product when used in a curable composition is aqueous developable. By "aqueous developable" herein is meant that the developer is water based and does not contain any organic solvents.

### 2. Description of the Prior Art

U.S. 4,370,403 teaches a photopolymerizable composition comprising a styrene-maleic anhydride copolymer in conjunction with (a) 2-hydroxyethyl acrylate, (b) additional ethylenic compounds and (c) a photoinitiator.

U.S. 4,415,651 teaches a monomer-free photosensitive composition comprising (a) a polyene having a number average molecular weight of about 1,000 to 1,000,000, (b) a reactive mercapto acid and (c) a radiation-sensitive, radical-generating system activatable by actinic radiation to initiate addition of the mercapto acid to the polyene.

U.S. 4,104,241 teaches a composition of matter comprising (a) a thermosetting internally unsaturated polyester resin and (b) an adduct of (1) a polymer formed from a liquid monomer selected from the group consisting of styrene, substituted styrenes, lower alkyl esters of acrylic and methacrylic acids, cyclic acrylates and diallyl phthalate and an unsaturated dicarboxylic acid selected from the group consisting of maleic anhydride, fumaric acid, citraconic acid, itaconic acid and chloromaleic acid and (2) a hydroxy-alkyl unsaturated monomer having the formula:

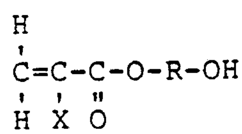

wherein X is hydrogen or methyl and R is an alkyl group containing from 1 to 10 carbon atoms and wherein said adduct is capable of polymerizing with the thermosetting unsaturated polyester.

U.S. 4,401,793 teaches an anaerobic composition comprising (a) about 5-95% by weight of a polymerizable, anaerobically curable $C_2$-$C_5$ hydroxyalkyl acrylate or methacrylate monomer, (b) about 5-95% by weight of a polymerizable polymeric adduct having pendant double bonds as a reactive thickener: the adduct being the addition reaction product of the $C_2$-$C_5$ hydroxyalkyl acrylate or methacrylate monomer of (a) and an anhydride-containing polymer derived from about 0.5-50 mole percent maleic, citraconic or itaconic anhydride and about 50-99.5 mole percent of a monomer having the formula $CH_2=C(R')X$, wherein R' is H, $CH_3$ or CN, X is a phenyl or COOR group and R is a halogen substituted or unsubstituted $C_1$-$C_{20}$ alkyl group or a halogen, alkoxy or ester substituted or unsubstituted $C_7$-$C_{20}$ aralkyl group, the adduct being free of unreacted anhydride groups, (c) 0-15% by weight of a carboxyl-containing monomer and (d) a free radical inhibitor in sufficient concentration to initiate cure upon the exclusion of oxygen.

U.S. 4,008,341 teaches a composition curable in the presence of a free radical generating agent comprising (a) 98 to 2% by weight of the composition of a liquid polyene component of the formula $[A]-(X)_m$ wherein m is an integer of at least 2, X is:

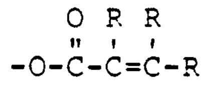 or 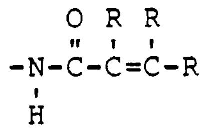

and A is a polyvalent organic moiety. free of reactive carbon-to-carbon unsaturation and of highly water-sensitive members and consisting of atoms selected from the group consisting of carbon. hydrogen. oxygen. nitrogen. chlorine. bromine. fluorine. phosphorous and silicon: and R is a radical selected from the group consisting of hydrogen. phenyl and an alkyl containing 1 to 9 carbon atoms. and (b) 2 to 98% by weight of the composition of a polythiol having a molecular weight in the range from about 94 to 20,000 of the general formula $R_8$-$(SH)_n$ wherein $R_8$ is a polyvalent organic moiety and n is at least 2. the reactive unsaturated carbon-to-carbon bonds per molecule in the polyene and the thiol groups per molecule in the polythiol being greater than 4 and up to about 50% by weight of the polyene.polythiol composition of a photocuring rate accelerator.

## OBJECTS OF THE INVENTION

One object of the invention is to prepare a novel composition of matter. Another object of the invention is to prepare a novel composition which is liquid and which is curable by a free radical mechanism. Still another object of the invention is to prepare a curable composition which after exposure imagewise to a free radical mechanism. e.g.. heat. UV or high energy ionizing radiation is aqueous-developable. These and other objects will become apparent from a reading hereinafter.

These and other objects are obtained from an aqueous developable, curable composition comprising the reaction product of a mono(meth)acrylate derivative of a caprolactone diol and a styrene-maleic anhydride copolymer.

The exposure of the composition optionally also with a reactive diluent, photo-or thermal initiator to heat. UV or high energy ionizing radiation results in aqueous developable printing plates, photoresists and the like.

In the instant invention the caprolactone diol is made by reacting a diol of the formula $R(OH)_2$ with a caprolactone of the formula:

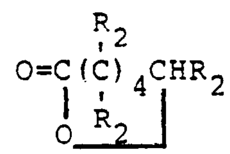

which can be caprolactone itself or a substituted caprolactone wherein $R_2$ is independently halogen. an alkyl. alkoxy. aryl. cycloalkyl. alkaryl or aralkyl group having up to twelve carbon atoms and wherein at least six of the $R_4$ groups are hydrogen atoms. as taught in U.S. Patent 3.169,945. The caprolactone diols that are used herein can have an average molecular weight of from 200 to about 2.000. The preferred caprolactone diol compounds are those having an average molecular weight of from about 300 to about 1.000.

Diols that are suitable to react with the caprolactone include, but are not limited to. glycols of the formula $HO(CH_2)_nOH$ in which n equals 2 to 10. glycols of the formulae $HO(CH_2CH_2O)_nH$ and $HO[CH(CH_3)$-$CH_2O]_nH$ in which n equals 1 to 40. such as ethylene glycol. diethylene glycol and the like. 2.2-dimethyl-1.3-propanediol. 2,2-diethyl-1.3-propanediol. 3-methyl-1.5-pentanediol. N-methyl and N-ethyl diethanol amine. various cyclohexanediols,

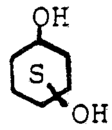

4,4'-methylenebiscyclohexanol,

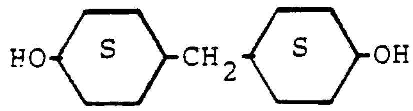

4,4'-isopropylidenebicyclohexanol,

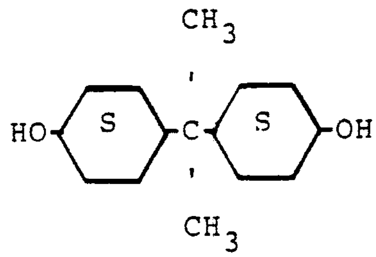

various xylenediols,

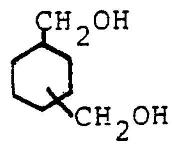

various hydroxymethyl-phenethyl alcohols,

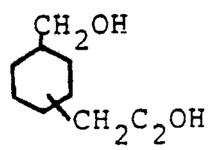

various hydroxymethyl-phenylpropanols,

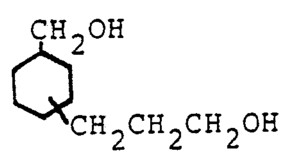

various phenylenediethanols,

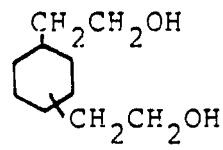

various phenylenedipropanols,

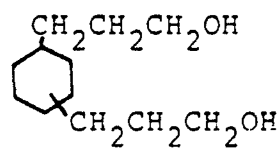

and various heterocyclic diols such as 1,4-piperazine-diethanol,

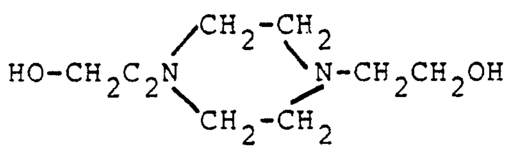

The monofunctional acrylate derivative may be prepared by reacting the caprolactone diol with acrylic or methacrylic acid in the presence of a strong acid catalyst. The strong acid catalyst may be sulfuric. methanesulfonic or p-toluenesulfonic acid, or ion exchange resins and the like. The catalyst is used in amounts of from about 0.1 to about 5.0, preferably from about 0.5 to about 2.0 percent.

The reaction to prepare the monofunctional (meth)acrylate monomer is carried out at a temperature of from about 60° to about 120°C, preferably from about 80° to about 105°C. The reaction may be carried out at atmospheric pressure, although higher or lower pressures may be used. The reaction is generally carried out in the presence of air (oxygen) to prevent polymerization of the acrylic function. Oxygen is generally sparged through the reaction during the course of the reaction. The reaction is carried out for a period of time until the theoretical water is removed or until no further water is produced. This period is generally from about 3 to about 8 hours.

The reaction is generally carried out in the presence of a solvent of the type which removes water formed during the reaction as an azeotrope. Among the suitable solvents which can be used are the hydrocarbons such as octane, heptane, hexane, benzene, toluene or the xylenes, etc.

The reaction is generally carried out in the presence of a suitable inhibitor or combination of inhibitors to prevent polymerization of the acrylic or methacrylic acid double bonds. These inhibitors include the monomethyl ether of hydroquinone, benzoquinone, phenothiazine, methylhydroquinone, methylene blue, 2,5-di-t-butylhydroquinone, hydroquinone and other common free radical inhibitors known in the art. The level of inhibitor used is from about 50 parts per million to about 2.0 percent.

In the reaction, one hydroxyl equivalent of the caprolactone diol is reacted with excess of acrylic acid or methacrylic acid to form the caprolactone diol acrylate.

The process of this invention may be carried out by adding the caprolactone diol and solvent and then adding the acrylic or methacrylic acid, inhibitor and catalyst to a reaction vessel and then heating this to the reflux temperature. During the reaction, oxygen (or air) is continually bubbled through the reaction. After the reaction is complete, the excess acid may be removed by, for example, neutralization by adding a strong base such as sodium or potassium hydroxide, or stripping it off by conventional techniques, or by an ion exchange resin. Excess water may be removed from the reaction by, for example, adding a conventional drying agent such as magnesium sulfate, or by the use of vacuum stripping which also removes the solvent. Air must be sparged into the reaction mixture during stripping.

The mono(meth)acrylate derivative of a caprolactone diol used as a reactant in the instant invention is taught in U.S. 3,700,643 and is commercially available from Union Carbide under the tradename "TONE M-100". This reactant is produced by the process set out in U.S. 4,632,975.

Styrene-maleic anhydride copolymeric resins operable herein are widely used in many applications

such as paints, sizing agents for textiles, aqueous printing inks and the like. These resins are commercially available, e.g., from ARCO Chemical Co. under the tradename "SMA Resin", and from Monsanto Chemical Co. under the tradename "SCRIPSET Resin", respectively. The styrene-maleic anhydride copolymeric resins generally have a molecular weight of from 700 to 250,000. The styrene-maleic anhydride copolymeric resins useful in the present invention have a molecular weight of from 1,000 to 3,000 and have a 3:1 to 1:1 mole ratio of styrene to maleic anhydride.

These styrene-maleic anhydride copolymers are reacted with a mono(meth)acrylate derivative of a caprolactone diol, the mole ratio of the mono(meth)acrylate derivative of the caprolactone diol to the anhydride in the styrene-maleic anhydride copolymer being in the range 0.25 - 1.25, preferably 1.0 to 1.0.

In forming the reaction product of the styrene-maleic anhydride copolymer and a mono(meth)acrylate derivative of the caprolactone diol, the reaction can be carried out neat but is usually carried out in the presence of a diluent which is reactive on curing. The reaction is usually carried out with stirring at a temperature of 20 to 130°C for periods ranging from 0.1 to 48 hours.

If desired, although not necessary, a catalyst can be used to increase the reaction rate. Catalysts operable herein include well known strong acid catalysts such as sulfuric, methanesulfonic or p-toluenesulfonic acid as well as tin catalysts such as stannous octoate and dibutyl tin dilaurate.

Ethylenically unsaturated (meth)acrylates of the formula:

$$(CH_2{=}\overset{R_2}{\overset{|}{C}}-\underset{\overset{\|}{O}}{C}-O)_n-R_3$$

wherein $R_2$ is H or $CH_3$, $R_3$ is an organic moiety and n is 1 or more, can be used as a diluent in which the reaction product can be formed. Such diluents which are reactive on curing include, but are not limited to, trimethylolpropane triacrylate, hexanediol diacrylate, 1,3-butylene glycol diacrylate, diethylene glycol diacrylate, 1,6-hexanediol diacrylate, neopentyl glycol diacrylate, polyethylene glycol-200 diacrylate, tetraethylene glycol diacrylate, triethylene glycol diacrylate, pentaerythritol tetraacrylate, tripropylene glycol diacrylate, ethoxylated bisphenol-A diacrylate, di-trimethylolpropane tetraacrylate, triacrylate of tris-(hydroxyethyl) isocyanurate, dipentaerythritol hydroxypentaacrylate, pentaerythritol triacrylate, ethoxylated trimethylolpropane triacrylate, triethylene glycol dimethacrylate, ethylene glycol dimethacrylate, tetraethylene glycol dimethacrylate, polyethylene glycol-200 dimethacrylate, 1,6-hexanediol dimethacrylate, neopentyl glycol dimethacrylate, polyethylene glycol-600 dimethacrylate, 1,3-butylene glycol dimethacrylate, ethoxylated bisphenol-A dimethacrylate, trimethylolpropane trimethacrylate, diethylene glycol dimethacrylate, 1,4-butanediol diacrylate, pentaerythritol tetramethacrylate, glycerin dimethacrylate, trimethylolpropane dimethacrylate, pentaerythritol trimethacrylate, pentaerythritol dimethacrylate, pentaerythritol diacrylate, isobornyl acrylate, isobornyl methacrylate, ethyl acrylate, ethoxyethoxyethyl acrylate, tetrahydrofurfuryl methacrylate, cyclohexyl methacrylate and the like which can be added to the composition to modify the cured product.

The mechanism of the curing reaction may be initiated by most any free radical mechanism. Generally, the rate of the curing reaction may be increased by increasing the temperature of the composition at the time of initiation of cure. In many applications, however, the curing is accomplished conveniently and economically by operating at ordinary room temperature conditions. Thus, when using UV to cure a coating, it is possible merely to photoexpose the composition, preferably with a photoinitiator, at ambient conditions and obtain a photocured solid product.

The free radical generating agent used to cure the composition of the instant invention can be in various forms including high energy ionizing radiation, actinic radiation and heat.

The preferred free radical generator for the curing reaction is actinic radiation, suitably in the wavelength of about 200 to 750 nanometers, preferably from 200 to 400 nanometers.

A class of actinic light useful herein is ultraviolet light and other forms of actinic radiation which are normally found in radiation emitted from the sun or from artificial sources such as Type RS Sunlamps, carbon arc lamps, xenon arc lamps, mercury vapor lamps, tungsten halide lamps and the like.

It is to be understood, however, that, when energy sources, e.g., ionizing radiation, other than visible or ultraviolet light, are used to initiate the curing reaction, photoinitiators generally are not required in the formulation.

To cure the reaction product composition with or without a reactive diluent, a photoinitiator is usually added when UV radiation is used for curing. Preferred photoinitiators are carbonyl compounds having at

least one aromatic nucleus attached directly to the carbonyl group. Various photo-initiators include, but are not limited to, benzophenone, acetophenone, o-methoxybenzophenone, acenapthene-quinone, methyl ethyl ketone, valerophenone, hexanophenone, alpha-phenylbutyrophenone, p-morpholinopropiophenone, dibenzosuberone, 4-morpholinobenzophenone, 4'-morpholinodeoxybenzoin, p-diacetylbenzene, 4-aminobenzophenone, 4-methoxyacetophenone, benzaldehyde, alpha-tetralone, 9-acetylphenanthrene, 2-acetylphenanthrene, 10-thioxanthenone, 3-acetylphenanthrene, 3-acetylindone, 9-fluorenone, 1,3,5-triacetylbenzene, xanthrene-9-one, 7-H-benz[de]anthracen-7-one, 1-naphthaldehyde, 4,4'-bis(dimethylamino)-benzophenone, fluorene-9-one, 1'-acetonaphthone, 2'-acetonaphthone, 2,3-butanedione, acetonaphthone, benz[a]anthracene-7,12-dione, benzil, etc. Another class of photoinitiators is the benzoin alkyl ethers, such as benzoin methyl ether, benzoin ethyl ether, benzoin isopropyl ether and benzoin isobutyl ether. Still another class of photoinitiators are the dialkoxyacetophenones exemplified by 2,2-dimethoxy-2-phenylacetophenone and 2,2-diethoxy2-phenylacetophenone. Phosphine compounds such as triphenylphosphine and tri-o-tolylphosphine are also operable herein as photoinitiators. The photoinitiators or mixtures thereof are usually added in an amount ranging from 0.01 to 10% by weight of the reaction product.

To cure the reaction product composition with or without a reactive diluent, a thermal initiator is usually added when heat is used for curing. The thermal initiators used herein for heat curing the reaction product composition are free radical initiators selected from substituted or unsubstituted pinacols, azo compounds, organic peroxides and mixtures thereof. These initiators are added in amounts ranging from 0.01 to 10% by weight of the total composition.

The organic peroxides operable are of the general formula:

$R-O-O-(R_1-O-O)_n-R$

wherein n = 0 or 1, R is independently selected from hydrogen, aryl, alkyl, aryl carbonyl, alkaryl carbonyl, aralkyl carbonyl and alkyl carbonyl and $R_1$ is alkyl or aryl, said alkyl groups containing 1 to 20 carbon atoms.

Examples of operable organic peroxides include, but are not limited to 2,5-dimethyl-2,5-di(t-butylperoxy)hexane, 1,3-bis(t-butylperoxyisopropyl)benzene, 1,3-bis-(cumylperoxyisopropyl)benzene, 2,4-dichlorobenzoyl peroxide, caprylyl peroxide, lauroyl peroxide, t-butyl peroxyisobutyrate, benzoyl peroxide, p-chlorobenzoyl peroxide, hydroxyheptyl peroxide, di-t-butyl diperphthalate, t-butyl peracetate, t-butyl perbenzoate, dicumyl peroxide, 1,1-di(t-butylperoxy)-3,3,5-trimethylcyclohexane and di-t-butyl peroxide.

Examples of azo compounds operable herein include, but are not limited to, commercially available compounds such as 2-t-butylazo-2-cyanopropane; 2,2'-azobis-(2,4-dimethyl-4-methoxy-valeronitrile); 2,2'-azobis-(isobutyronitrile); 2,2'-azobis(2,4-dimethylvaleronitrile) and 1,1'-azobis(cyclohexanecarbonitrile).

The substituted or unsubstituted pinacols operable herein as a thermal initiator have the general formula:

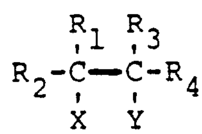

wherein $R_1$ and $R_3$ are the same or different substituted or unsubstituted aromatic radicals, $R_2$ and $R_4$ are substituted or unsubstituted aliphatic or aromatic radicals and X and Y which may be the same or different are hydroxyl, alkoxy or aryloxy.

Preferred pinacols are those wherein $R_1$, $R_2$, $R_3$ and $R_4$ are aromatic radicals, especially phenyl radical, and X and Y are hydroxyl.

Examples of this class of compounds include, but are not limited to, benzopinacol, 4,4'-dichlorobenzopinacol, 4,4'-dibromobenzopinacol, 4,4'-diiodobenzopinacol, 4,4',4",4'"-tetrachlorobenzopinacol, 2,4-2',4'-tetrachlorobenzopinacol, 4,4'-dimethylbenzopinacol, 3,3'-dimethylbenzopinacol, 2,2'-dimethylbenzopinacol, 3,4-3',4'-tetramethylbenzopinacol, 4,4'-dimethoxybenzopinacol, 4,4',4",4'"-tetramethoxybenzopinacol, 4,4'-diphenylbenzopinacol, 4,4'-dichloro-4",4'"-dimethylbenzopinacol, 4,4'-dimethyl-4",4'"-diphenylbenzopinacol, xanthonpinacol, fluorenonepinacol, acetophenonepinacol, 4,4'-dimethylacetophenone-pinacol, 4,4'-dichloroacetophenonepinacol, 1,1,2-triphenyl-propane-1,2-diol, 1,2,3,4-tetraphenylbutane-2,3-diol, 1,2-diphenylcyclobutane-1,2-diol, propiophenone-pinacol, 4,4'-dimethylpropiophenone-pinacol, 2,2'-ethyl-3,3'-dimethoxypropiophenone-pinacol, 1,1,1,4,4,4-hexafluoro-2,3-diphenyl-butane-2,3-diol.

As further thermal initiators according to the present invention, there may be mentioned: benzopinacol

monomethylether, benzopinacol monophenylether, benzopinacol monoisopropyl ether, benzopinacol monoisobutyl ether, benzopinacol mono (diethoxymethyl) ether and the like.

In the instant invention a preferred curable composition comprises the reaction product in an amount ranging from 5 to 100% by weight of the composition. The reactive diluent may be added in an amount ranging from 0 to 95% by weight of the composition. The thermal initiator or photoinitiator is added in an amount ranging from 0.01 to 10% by weight of the composition.

The curable compositions incorporating the reaction product of the present invention may, if desired, include such conventional additives as antioxidants, accelerators, dyes, inhibitors, activators, fillers, pigments, anti-static agents, flame-retardant agents, thickeners, thixotropic agents, surface-active agents, viscosity modifiers, extending oils, plasticizers, tackifiers and the like within the scope of this invention. Such additives are usually blended into the composition during the compounding step. Operable fillers include natural and synthetic resins, carbon black, glass fibers, wood flour, clay, silica, alumina, carbonates, oxides, hydroxides, silicates, glass flakes, glass beads, borates, phosphates, diatomaceous earth, talc, kaolin, barium sulfate, calcium sulfate, calcium carbonate, antimony oxide and the like. The aforesaid additives may be present in effective quantities up to 500 parts or more per 100 parts of the composition by weight and preferably about 0.0005 to about 300 parts on the same basis.

The following examples will aid and explain, but expressly not limit, the instant invention. Unless otherwise noted, all parts and percentages are by weight.

Example 1

A mixture of 75.0 g SMA[R]-1000A (from ARCO Chemical Co.); 107.1 g Tone[R]M-100 (hydroxycaprolactone acrylate, commercially available from Union Carbide Corp.); 0.18 g hydroquinone and 1.24 g stannous octoate were charged into a 500 ml resin kettle equipped with a stirrer and thermometer. The mixture was agitated to form a slurry and then heated to 100°C. The agitated reaction mixture was heated at 100-105°C for 3 hours and then 0.09 g p-methoxyphenol was added. The mixture was heated at 100-105°C for 3 to 4 more hours and then discharged into a container. The reaction product was a very viscous liquid at room temperature and had a Brookfield Thermosel RVTDV-II viscosity of 82,600 cps at 90°C using a #21 spindle. Infrared spectrophotometry at 1,770 $cm^{-1}$ and 1,830 $cm^{-1}$ indicated only a residual amount of anhydride remaining. The resultant product will hereinafter be referred to as Oligomer A.

Example 2

A mixture of 75.0 g SMA[R]-1000A (from ARCO Chemical Co.); 65.2 g Tone[R]M-100 (hydroxycaprolactone acrylate, commercially available from Union Carbide Corp.); 16.4 g hydroxyethyl methacrylate (from Rohm & Haas); 27.6 g GPTA (glyceryl propoxy triacrylate from Celanese); 0.18 g hydroquinone and 1.1 g stannous octoate were charged into a 500 ml resin kettle equipped with a stirrer and thermometer. The mixture was agitated to form a slurry and then heated to 100°C. The agitated reaction mixture was heated at 95-105°C for 6-7 hours and then discharged into a glass jar. The reaction product was a viscous liquid at room temperature and had a Brookfield RVT Thermosel viscosity of 27,000 cps at 80°C using a #21 spindle.

Example 3

A mixture of 75.0 g SMA[R]-1000A (from ARCO Chemical Co.); 107.1 g Tone[R]M-100 (hydroxycaprolactone acrylate, commercially available from Union Carbide Corp.); 20.4 g of Photomer-4072 (propoxylated trimethylolpropane triacrylate, commercially available from Diamond Shamrock): 0.2 g hydroquinone and 1.4 g stannous octoate were charged into a 500 ml resin kettle equipped with a stirrer and thermometer. The mixture was agitated to form a slurry and then heated to 100°C. The reaction mixture was heated at 100-105°C for 6-7 hours and then discharged into a glass jar. The reaction product was a very viscous liquid at room temperature. The Brookfield Thermosel RVTDV-II viscosity was 30,000 cps at 80°C using a #21 spindle. The resultant mixture will hereinafter be referred to as Oligomer Mixture I.

Example 4

Formulation A

The following materials were mixed together at 80°C to make Formulation A:

| Material | Grams |
|---|---|
| Oligomer Mixture I (from Example 3) | 36.65 |
| Photomer-6173 (phthalic acid, hydroxyethyl acrylate monoester, from Diamond Shamrock) | 5.00 |
| p-Methoxyphenol (Aldrich) | 0.03 |
| Pyrogallol (Fisher) | 0.02 |
| Triisooctyl phosphite (Mobil Chemical) | 0.28 |
| Phosphoric acid | 0.03 |
| Irgacure-651 (Ciba-Geigy) | 1.00 |
| Benzophenone | 1.00 |
| Penn Blue-9S87 | 1.00 |

Formulation A (at 80°C) was drawn down at 3-4 mils of thickness using a zero drawdown bar, onto a double-sided, 1 oz. copper, electroless plated laminate board with a 0.060 in. epoxy-glass core. The surface was covered with a clear polyester film, 0.001 in. thick. The coated board with the polyester cover film was contact imaged through a phototool using a 7-second exposure from an Optical Radiation Corp., collimated UV lamp with an intensity of 13 milliwatts.cm$^2$. The polyester cover film was removed from the imaged board and the board spray developed to remove uncured formulation in a Chemcut developer unit containing an 0.7% aqueous sodium carbonate solution. An image of a circuit formed from the cured formulation was left on the board. The copper was exposed where the uncured formulation was removed during development. The developed board with the circuit image was placed in an agitated 55°C etch solution as used in Example I, for 300 seconds to remove all the exposed copper and leaving the copper protected by the cured formulation. The etched board was rinsed in water, then placed in a 6.5% aqueous solution of sodium hydroxide at 60-64°C and shaken in the solution for 30 seconds to fully strip the cured formulation, exposing the underlying circuit.

Example 5

A mixture of 75.0 g SMA$^R$-1000A (from ARCO Chemical Co.); 107.1 g Tone$^R$M-100 (hydroxycaprolactone acrylate, commercially available from Union Carbide Corp.); 32.4 g GPTA (glyceryl propoxy triacrylate from Celanese); 0.03 g p-methoxyphenol; 0.22 g pyrogallol and 1.4 g stannous octoate were charged into a 500 ml resin kettle equipped with a stirrer and thermometer. The mixture was agitated to form a slurry and then heated to 100°C. The agitated reaction mixture was heated at 95-105°C for 6-7 hours and then discharged into a glass jar. The reaction product was a viscous liquid at room temperature and had a Brookfield Thermosel RVTDV-II viscosity of 13,000 cps at 80° using a #21 spindle. The resultant mixture will hereinafter be referred to as Oligomer Mixture II.

Example 6

Oligomer Mixture II was coated onto the bottom of a glass dish at 5 to 20 mils thick. The coated dish was then passed under two 200 W in. medium pressure Hg lamps (Colight) at 10 ft min. until the mixture was solid. The viscous liquid was surface cured tack-free in one pass and was through-cured in two passes to a flexible solid.

Example 7

Oligomer A (15.8 g) from Example 1 was warmed to 60-80°C and 0.16 g of Lupersol-231, i.e.. 1.1-bis(t-butylperoxy)-3.3.5-trimethylcyclohexane, commercially available from Lucidol Div. of Pennwalt Corp.. was mixed into the oligomer. 5 g of the mixture were placed into an aluminum weighing dish and then heated in a 120°C oven for 20 minutes after which time the mixture was solid. The cured mixture was a tough flexible solid at room temperature. A control sample of Oligomer A per se heated at 120°C for 20 minutes remained a liquid.

## Claims

1. A curable, aqueous developable composition comprising the reaction product of a mono(meth)-acrylate derivative of a caprolactone diol and a styrene-maleic anhydride copolymer.

2. The composition of Claim 1 in a reactive diluent comprising a member of the group consisting of an ethylenically unsaturated (meth)acrylate of the formula:

$$(CH_2{=}\overset{R_2}{\overset{|}{C}}{-}\underset{\underset{O}{\|}}{C}{-}O)_{\overline{n}}\ R_3$$

wherein $R_2$ is H or $CH_3$, $R_3$ is an organic moiety and n is 1 or more.

3. The composition according to Claim 2 wherein the reactive diluent is present in an amount ranging up to 95% by weight of the composition.

4. The composition of Claim 1 wherein the mono(meth)acrylate derivative of a caprolactone diol is

$HO(CH_2)_5CO_2(CH_2)_5CO_2(CH_2)_2OCOCH=CH_2$